# EUROPEAN PATENT APPLICATION

(11) **EP 4 783 752 A1**
(43) Date of publication of application: **29.07.2026**
(21) Application number: 26152640.4
(22) Date of filing: 19.01.2026
(51) Int. Cl.: H05K 1/02, H10W 40/22, H10W 40/20, H10W 42/20, G06F 1/20

(54) **HEAT DISSIPATION STRUCTURE FOR SEMICONDUCTOR PACKAGE MODULE AND ELECTRONIC DEVICE INCLUDING THE SAME**

(30) Priority: 22.01.2025 KR 20250009436
(71) Applicant: Unick Corporation, Gimhae-si, Gyeongsangnam-do 50870 (KR)
(72) Inventor: ROH, Eui-Dong, 50870 Gyeongsangnam-do (KR); CHOI, Wook-Hyun, 50870 Gyeongsangnam-do (KR); KIM, Tae-Yong, 50870 Gyeongsangnam-do (KR); HAN, Seung-Min, 50870 Gyeongsangnam-do (KR); KANG, Min-Ho, 50870 Gyeongsangnam-do (KR)
(74) Representative: Zacco Sweden AB

(57) **Abstract**

The present disclosure relates to a heat dissipation structure for a semiconductor package module capable of more effectively dissipating heat generated by a semiconductor device, and an electronic device including the same, in which circuit patterns are provided on at least one surface of a substrate, a semiconductor device is mounted on one surface of the substrate on which the circuit patterns are provided, and a heat dissipation trace for dissipating heat generated by the semiconductor device is formed on the substrate.

## Description

### TECHNICAL FIELD

The present disclosure relates to a heat dissipation structure for a semiconductor package module and an electronic device including the same, and more particularly, to a heat dissipation structure for a semiconductor package module that may more effectively dissipate heat generated from a semiconductor device, and an electronic device including the same.

### BACKGROUND

The present disclosure relates to a heat dissipation structure for a semiconductor package module and an electronic device including the same, and more particularly, to a heat dissipation structure for a semiconductor package module that may more effectively dissipate heat generated from a semiconductor device, and an electronic device including the same.

### [Prior Art Documents]

### [Patent Documents]

(Patent Document 1) U.S. Patent No. 5,907,189 (May 25, 1999)

### SUMMARY

The present disclosure has been made to address the problems of the conventional art described above, and an object thereof is to provide a heat dissipation structure for a semiconductor package module that may more effectively dissipate heat generated from a semiconductor device, and an electronic device including the same.

A heat dissipation structure for a semiconductor package module according to the present disclosure for achieving the above object is provided, in which circuit patterns are provided on at least one surface of a substrate, and a semiconductor device is mounted on one surface of the substrate on which the circuit patterns are provided, and a heat dissipation trace for dissipating heat generated by the semiconductor device is formed on the substrate.

Here, the heat dissipation trace may be electrically and physically separated from the circuit patterns, and the semiconductor device may be disposed on the heat dissipation trace and is connected to the circuit patterns.

Here, a first heat dissipation hole for dissipating heat generated by the semiconductor device may be formed in the heat dissipation trace, and a thermal pad may be provided on another surface of the heat dissipation trace, and heat generated by the semiconductor device may be transferred through the first heat dissipation hole to the thermal pad and dissipated.

Here, a coating layer may be applied to at least a portion of a surface of the semiconductor device, and at least a portion of the semiconductor device to which the coating layer is applied may be sealed by a shielding member. Here, a second heat dissipation hole for dissipating heat generated by the semiconductor device may be formed in the shielding member.

As configured as described above, the present disclosure may effectively dissipate heat generated during operation of a semiconductor device by forming a heat dissipation trace on a substrate on which the semiconductor device is mounted.

In addition, in the present disclosure, the semiconductor device and a thermal pad provided on an opposite side thereof are connected through a first heat dissipation hole, such that heat generated from the semiconductor device may be transferred to the thermal pad and dissipated to the outside, thereby improving heat dissipation efficiency.

In addition, in the present disclosure, by applying a coating layer to the semiconductor device and adding a shielding member, damage due to contaminants such as moisture and dust may be prevented, and interference caused by electromagnetic waves may be blocked.

In particular, when a second heat dissipation hole is formed in the shielding member, heat generated from the semiconductor device may be more effectively dissipated, and problems such as moisture condensation due to temperature changes of the semiconductor device may be improved.

In addition to the effects described above, specific effects of the present disclosure will be described together below while explaining detailed matters for carrying out the disclosure.

### BRIEF DESCRIPTION OF THE DRAWINGS

FIG. 1 is a perspective view of a heat dissipation structure for a semiconductor package module according to an embodiment of the present disclosure.
FIG. 2 is an exploded perspective view of a heat dissipation structure for a semiconductor package module according to an embodiment of the present disclosure.
FIG. 3 is a cross-sectional view of a heat dissipation structure for a semiconductor package module according to an embodiment of the present disclosure.
FIG. 4 is a perspective view of an electronic device including a heat dissipation structure for a semiconductor package module according to an embodiment of the present disclosure.
FIG. 5 is an exploded perspective view of an electronic device including a heat dissipation structure for a semiconductor package module according to an embodiment of the present disclosure.
FIG. 6 is a cross-sectional view of an electronic device including a heat dissipation structure for a semiconductor package module according to an embodiment of the present disclosure.

### DETAILED DESCRIPTION OF THE PREFERRED EMBODIMENTS

The above-described objects, features, and advantages will be described in detail below with reference to the accompanying drawings, and accordingly, a person having ordinary skill in the art to which the present disclosure pertains will be able to readily carry out the technical spirit of the present disclosure. In describing the present disclosure, detailed descriptions of well-known technologies related to the present disclosure will be omitted when it is determined that such descriptions may unnecessarily obscure the gist of the present disclosure. Hereinafter, preferred embodiments according to the present disclosure will be described in detail with reference to the accompanying drawings. In the drawings, the same reference numerals are used to denote the same or similar components.

Although terms such as first and second are used to describe various components, these components are not limited by such terms. These terms are merely used to distinguish one component from another, and unless otherwise specified, a first component may be a second component.

Throughout the specification, unless otherwise specified, each component may be singular or plural.

Hereinafter, a description that an arbitrary component is disposed on (or under) a component or on an upper (or lower) portion of a component may mean not only that the arbitrary component is disposed in contact with an upper surface (or a lower surface) of the component, but also that another component may be interposed between the component and the arbitrary component disposed on (or under) the component.

In addition, when a component is described as being "connected," "coupled," or "attached" to another component, it should be understood that the components may be directly connected or attached to each other, or that another component may be interposed therebetween, or that the components may be connected, coupled, or attached to each other through another component.

As used herein, singular forms include plural forms unless the context clearly indicates otherwise. In the present application, terms such as "configured" or "include" should not be construed as necessarily including all of the various components or steps described in the specification, and it should be understood that some components or steps may be omitted, or that additional components or steps may be further included.

Throughout the specification, the expression "A and/or B" means A, B, or both A and B unless otherwise specified, and the expression "C to D" means not less than C and not greater than D unless otherwise specified.

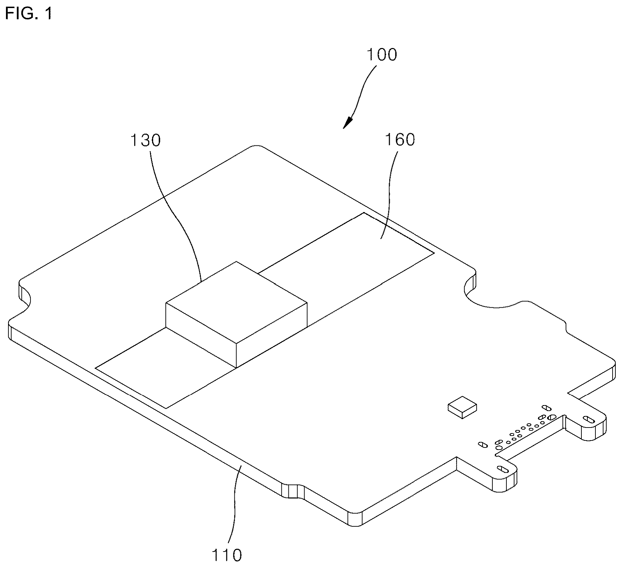

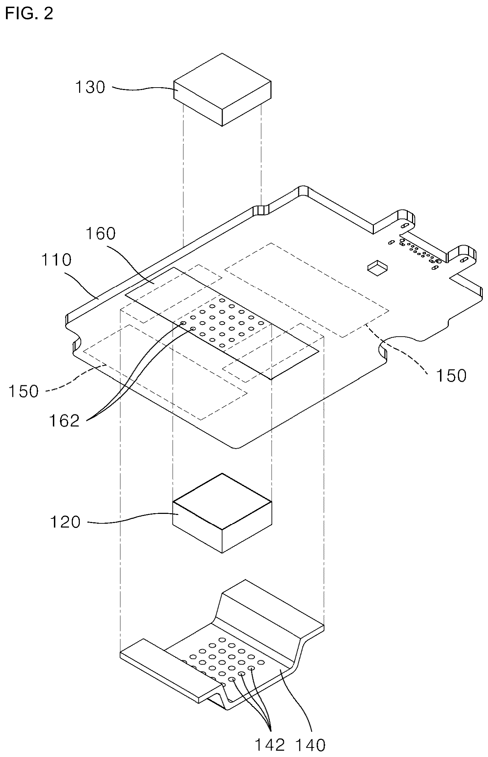

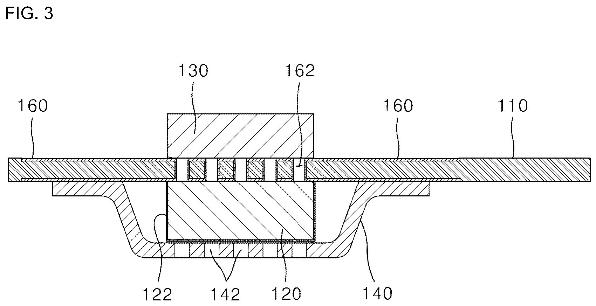

As shown in FIGS. 1 to 3, a heat dissipation structure for a semiconductor package module according to an embodiment of the present disclosure includes a substrate 110, a semiconductor device 120 mounted on the substrate 110, a thermal pad 130 configured to dissipate heat generated from the semiconductor device 120, and a shielding member 140 configured to protect the semiconductor device 120 from electromagnetic interference.

First, the substrate 110 is a printed circuit board (PCB) on which circuit patterns 150 for electrically connecting electronic components including the semiconductor device 120 are formed.

Such a substrate 110 is fabricated to have a structure capable of dissipating heat generated from the semiconductor device 120 to the outside, and in the present embodiment, a heat dissipation trace 160 is formed on the substrate 110 so that heat generated from the semiconductor device 120 may be dissipated to the outside.

In the present embodiment, the heat dissipation trace 160 is disposed in an intermediate portion of the substrate 110, more specifically, between circuit patterns 150 formed on the substrate 110, while being electrically and physically separated from the circuit patterns 150.

The semiconductor device 120 is disposed on one surface of the heat dissipation trace 160 (a lower surface in the drawings) so that heat may be dissipated through the heat dissipation trace 160. At this time, although not shown in the drawings, the semiconductor device 120 may be connected to the circuit patterns 150 through lead frames (not shown) protruding from both sides of the semiconductor device 120.

Meanwhile, a first heat dissipation hole 162 for transferring heat generated from the semiconductor device 120 is formed in the heat dissipation trace 160 on which the semiconductor device 120 is disposed, and a thermal pad 130 for dissipating heat transferred through the first heat dissipation hole 162 to the outside is provided on the other surface of the heat dissipation trace 160 (an upper surface in the drawings).

That is, with respect to the heat dissipation trace 160, the semiconductor device 120 is mounted on a lower surface thereof and the thermal pad 130 is provided on an upper surface thereof, and a first heat dissipation hole 162 is formed between the semiconductor device 120 and the thermal pad 130.

Accordingly, heat generated during operation of the semiconductor device 120 may be dissipated to the outside through the heat dissipation trace 160, and may also be transferred to the thermal pad 130 through the first heat dissipation hole 162 and dissipated to the outside, thereby significantly improving heat dissipation efficiency.

On the other hand, a coating layer 122 is applied to a surface of the semiconductor device 120 mounted on the lower surface of the heat dissipation trace 160.

For example, the coating layer 122 may be a conformal coating that protects the semiconductor device 120 from various environmental conditions, such as moisture, dust, chemicals, heat, and vibration, in order to maintain performance of the semiconductor device 120 and extend a lifespan thereof.

Materials for the conformal coating may include acrylic, silicone, polyurethane, epoxy, and parylene, and the conformal coating may be applied by methods such as spraying, brushing, dip coating, or vacuum deposition.

The semiconductor device 120 to which the coating layer 122 is applied is sealed by the shielding member 140.

The shielding member 140 serves to protect the semiconductor device 120 from electromagnetic interference, and also serves to dissipate heat generated from the semiconductor device 120, thereby preventing condensation of moisture around the semiconductor device 120.

To this end, a plurality of second heat dissipation holes 142 are formed in the shielding member 140.

According to the present embodiment configured as described above, a heat dissipation trace 160 is formed on the substrate 110 on which the semiconductor device 120 is mounted, thereby effectively dissipating heat generated during operation of the semiconductor device 120.

In addition, since the thermal pad 130 provided on an opposite side of the semiconductor device 120 is connected through the first heat dissipation hole 162, heat generated from the semiconductor device 120 may be transferred to the thermal pad 130 and dissipated to the outside, thereby significantly improving heat dissipation efficiency.

In addition, by applying a conformal coating layer 122 to a surface of the semiconductor device 120 and sealing the semiconductor device 120 through the shielding member 140, damage due to contaminants such as moisture and dust may be prevented, and interference caused by electromagnetic waves may be blocked.

In particular, through the second heat dissipation holes 142 formed in the shielding member 140, heat generated from the semiconductor device 120 may be more effectively dissipated, and problems such as moisture condensation due to temperature changes of the semiconductor device 120 may be addressed.

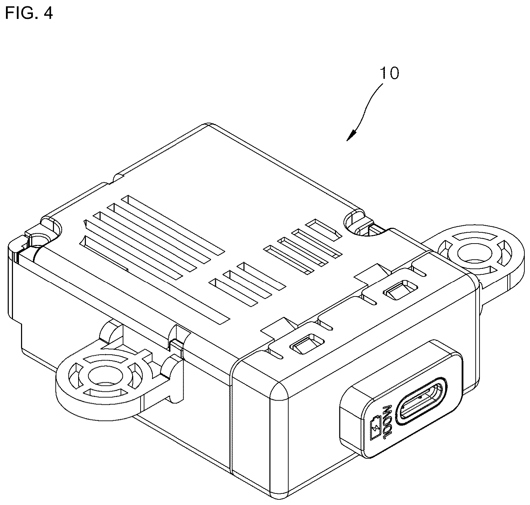

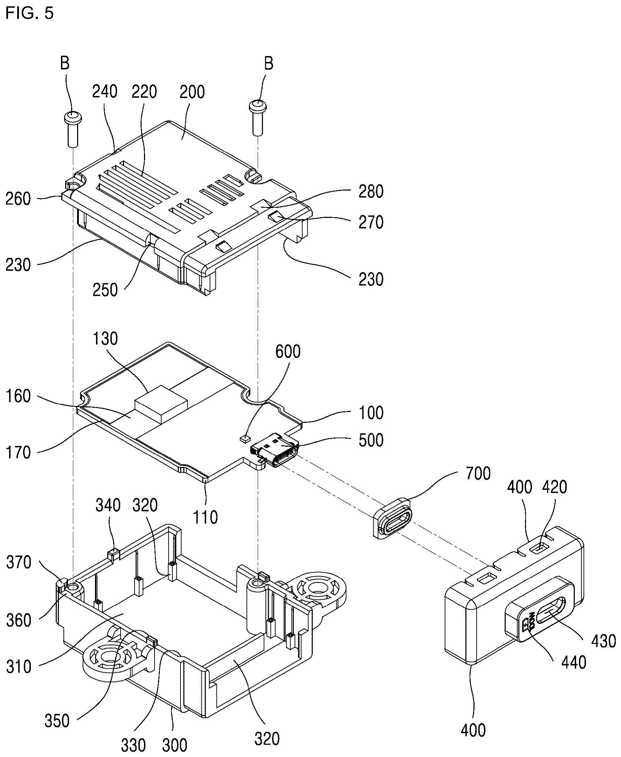

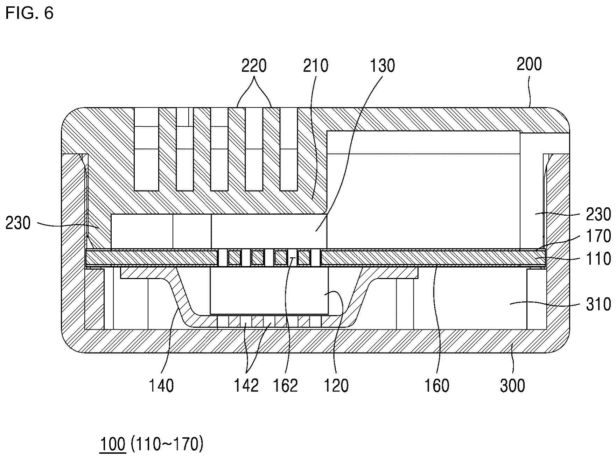

An electronic device to which the heat dissipation structure for a semiconductor package module according to the present embodiment is applied will now be described with reference to FIGS. 4 to 6.

As shown in the drawings, an electronic device 10 to which the heat dissipation structure for a semiconductor package module according to the present embodiment is applied may be a vehicular USB charger installed in a center fascia of a vehicle.

The vehicular USB charger 10 may include cases 200 to 400, a substrate module 100 provided inside the cases 200 to 400, and a USB receptacle 500 and a light source module 600 mounted on the substrate module 100.

Here, the substrate module 100 is one to which the heat dissipation structure for a semiconductor package module according to the present embodiment described above is applied, and thus a detailed description of the configuration of the substrate module 100 including the semiconductor device 120, the thermal pad 130, the shielding member 140, and the heat dissipation trace 160 will be omitted.

The cases 200 to 400 are components that form an exterior appearance of the vehicular USB charger 10, and have a thin rectangular box shape so as to be installed in a center fascia (not shown) or a console box (not shown) of a vehicle.

The cases 200 to 400 include case bodies 200 and 300, and a cover 400 coupled to a front end of the case bodies 200 and 300.

The case bodies 200 and 300 include an upper case 200 and a lower case 300 that are detachably coupled to each other so as to allow components such as the substrate module 100 installed therein to be replaced.

First, referring to the lower case 300, the lower case 300 has a half-pipe shape with a rectangular cross-section, and includes therein an accommodating space 310 for installation of the substrate module 100.

More specifically, the lower case 300 has a half-pipe shape in which a front end is open and a rear end is closed, such that a front-end portion of the substrate module 100 installed in the accommodating space 310 may be exposed to the outside.

The lower case 300 includes therein a holder 320 that supports the substrate module 100 installed in the accommodating space 310. In this case, the holder 320 may have a form of a rib protruding from a wall surface of the lower case 300 or a form of a flange protruding from a bottom of the lower case 300.

Stoppers 330 are formed on both side wall surfaces of the lower case 300. The stoppers 330 prevent the substrate module 100 installed in the accommodating space 310 from moving in a width direction of the lower case 300 (a front-rear direction in the drawing).

Meanwhile, the lower case 300 is provided with stopping protrusions 340 and 350 that define a coupling position with the upper case 200 and prevent movement of the upper case 200 that is temporarily coupled thereto.

Here, the stopping protrusions 340 and 350 include a first stopping protrusion 340 formed on a rear wall of the lower case 300 to prevent movement of the upper case 200 in a length direction (a left-right direction), and a second stopping protrusion 350 formed on a side wall of the lower case 300 to prevent movement of the upper case 200 in a width direction (a front-rear direction).

The lower case 300 described above may be made of acrylonitrile butadiene styrene (ABS) or polycarbonate (PC), which has high impact resistance and high rigidity, is easily formable when heated, and exhibits excellent heat resistance, chemical resistance, and insulating properties.

The upper case 200 has a half-pipe shape that covers the accommodating space 310 in which the substrate module 100 is installed. In this case, the upper case 200 is configured to have a structure capable of dissipating heat generated by the semiconductor device 120 during power charging and data transmission.

That is, the upper case 200 has a half-pipe shape corresponding to the lower case 300, and the upper case 200 is provided with heat dissipation portions 210 and 220 so as to effectively dissipate heat generated by the semiconductor device 120.

The heat dissipation portions 210 and 220 according to the present embodiment include a heat dissipation surface 210 provided on an inner side of the upper case 200 and in contact with the thermal pad 130, and heat dissipation fins 220 provided on an outer side of the upper case 200 to dissipate heat transferred through the heat dissipation surface 210.

The heat dissipation fins 220 extend in a width direction of the upper case 200 (a front-rear direction) to secure a contact area with outside air, and are provided in plurality and arranged at predetermined intervals along a length direction of the upper case 200 (a left-right direction).

Although not shown in the drawings, the heat dissipation fins 220 may be formed to have a cross-sectional area that decreases toward distal ends thereof, in which case a contact area with outside air may be increased to improve heat dissipation efficiency.

Meanwhile, the substrate module 100 of the vehicular USB charger 10 according to the present embodiment is provided with a heat dissipation film 170 to more effectively dissipate heat generated by the semiconductor device 120 and transferred through the heat dissipation trace 160.

The heat dissipation film 170 is formed along a periphery of an upper surface of the substrate 110 and is a film made of a copper foil material capable of effectively dissipating heat.

The heat dissipation film 170 may, in addition to dissipating heat to the outside, serve to guide a surge introduced into the substrate 110 to an external ground, and in this case, the circuit may be safely protected from the surge.

A contact portion 230 that comes into contact with the heat dissipation film 170 is formed on the upper case 200. The contact portion 230 extends along a periphery of the upper case 200 and protrudes from a bottom of the upper case 200 toward the substrate module 100, such that the contact portion 230 is brought into close contact with the heat dissipation film 170 when the upper case 200 is coupled.

As described above, when the contact portion 230 of the upper case 200 is in close contact with the heat dissipation film 170 of the substrate module 100, heat transferred through the heat dissipation trace 160 is directly delivered to the heat dissipation fins 220 of the upper case 200, thereby further improving heat dissipation efficiency.

Meanwhile, the upper case 200 is formed with a first stopping groove 240 corresponding to the first stopping protrusion 340 of the lower case 300, and a second stopping groove 250 corresponding to the second stopping protrusion 350 of the lower case 300.

As described above, the first stopping groove 240 prevents movement of the upper case 200 temporarily coupled to the lower case 300 in a length direction (a left-right direction), and the second stopping groove 250 prevents movement of the upper case 200 temporarily coupled to the lower case 300 in a width direction (a front-rear direction).

Unlike the lower case 300 described above, the upper case 200 is preferably made of a conductive material so as to effectively dissipate heat of the substrate module 100.

For example, the upper case 200 may be made of a thermal conductive plastic that is easily formable and has excellent thermal conductivity while reducing electrical conductivity by adding thermally conductive fillers such as aluminum, copper, carbon fiber, or ceramic.

As illustrated in the drawings, the upper case 200 and the lower case 300 are coupled to each other by fastening bolts B.

For this purpose, the upper case 200 is provided with a fastening portion 260 through which the fastening bolt B passes, and the lower case 300 is formed with a coupling portion 360 to which the fastening bolt B is screw-coupled.

Here, the fastening portion 260 has a C-shaped configuration with one side open, which is intended to prevent an edge of the fastening portion 260, which is a rigidity-vulnerable portion, from being damaged by the fastening bolt B during a process of coupling the case bodies 200 and 300.

In other words, since the upper case 200 made of a heat-dissipating plastic material to which a thermally conductive filler is added has lower rigidity than the lower case 300, opening one side of the fastening portion 260 as described above may prevent damage caused by stress concentration.

A stopper 370 that is inserted into the open one side of the fastening portion 260 protrudes from one side of the coupling portion 360. The stopper 370 serves to define a coupling position of the upper case 200 and the lower case 300, and preferably protrudes to a lower height than the fastening portion 260 so that the upper case 200 and the lower case 300 may be brought into close contact with each other.

Meanwhile, a locking protrusion 270 for coupling with the cover 400 is formed around a front end periphery of the case bodies 200 and 300 composed of the upper case 200 and the lower case 300, and a rework groove 280 for detaching the cover 400 is formed around the locking protrusion 270.

The cover 400 has a pipe shape with a rectangular cross-section that covers an open front end of the case bodies 200 and 300, and more specifically, has a pipe shape in which a front end is closed and a rear end is open.

Locking pieces 410 for coupling with the case bodies 200 and 300 are formed around a periphery of the cover 400, and each locking piece 410 is formed with a locking hole 420 into which the locking protrusion 270 is inserted.

A connection opening 430 into which a USB receptacle 500 is inserted is formed on a front surface of the cover 400, and an indicator portion 440 indicating a charging state is formed on one side of the connection opening 430.

Here, the USB receptacle 500 is exposed to the outside through the connection opening 430 and connected to a USB plug (not shown), and upon connection of the USB plug (not shown), a charging state may be checked through the indicator portion 440.

The substrate module 100 is mounted with a USB receptacle 500 for connection with an external device and a light source module 600 that emits light during power application and data transmission.

The USB receptacle 500 is a connector for connection with an external device, and in the present embodiment, a USB Type-C receptacle is exemplified, but the present disclosure is not necessarily limited thereto.

In addition, the light source module 600 serves as a means for emitting light when a USB plug (not shown) is connected to the USB receptacle 500 to indicate a charging and data transmission state, and in the present embodiment, an LED module is used.

Meanwhile, a prism 700 is installed around a front-end periphery of the substrate module 100 on which the light source module 600 is mounted. The prism 700 improves visibility by diffusing light generated by the light source module 600.

As described above with reference to the illustrated drawings by way of example, the present disclosure is not limited by the embodiments and drawings disclosed herein, and it will be apparent that various modifications may be made by those skilled in the art within the scope of the technical idea of the present disclosure. In addition, even though operational effects according to the configurations of the present disclosure have not been explicitly described in the foregoing embodiments, it should be appreciated that effects predictable from such configurations are also to be recognized.

## Claims

1. A heat dissipation structure for a semiconductor package module, wherein circuit patterns are provided on at least one surface of a substrate, and a semiconductor device is mounted on one surface of the substrate on which the circuit patterns are provided, and
wherein a heat dissipation trace for dissipating heat generated by the semiconductor device is formed on the substrate.

2. The heat dissipation structure of claim 1, wherein the heat dissipation trace is electrically and physically separated from the circuit patterns, and
wherein the semiconductor device is disposed on the heat dissipation trace and is connected to the circuit patterns.

3. The heat dissipation structure of claim 2, wherein a first heat dissipation hole for dissipating heat generated by the semiconductor device is formed in the heat dissipation trace.

4. The heat dissipation structure of claim 3, wherein a thermal pad is provided on another surface of the heat dissipation trace, and
wherein heat generated by the semiconductor device is transferred through the first heat dissipation hole to the thermal pad and dissipated.

5. The heat dissipation structure of claim 4, wherein a coating layer is applied to at least a portion of a surface of the semiconductor device, and at least a portion of the semiconductor device to which the coating layer is applied is sealed by a shielding member.

6. The heat dissipation structure of claim 5, wherein a second heat dissipation hole for dissipating heat generated by the semiconductor device is formed in the shielding member.

7. An electronic device comprising:
a case; and
a substrate provided inside the case,
wherein the substrate is applied with the heat dissipation structure of claim 1.

8. The electronic device of claim 7, wherein a thermal pad is provided on another surface of the heat dissipation trace, and
wherein the case is provided with a heat dissipation portion that is in contact with the thermal pad.

9. The electronic device of claim 8, wherein the heat dissipation portion includes a heat dissipation surface provided on an inner side of the case and in contact with the thermal pad, and heat dissipation fins provided on an outer side of the case to dissipate heat transferred through the heat dissipation surface.

10. The electronic device of claim 9, wherein an auxiliary heat dissipation trace is formed at an edge of the substrate, and
wherein the heat dissipation trace extends from a position at which the semiconductor device is mounted to the auxiliary heat dissipation trace.

11. The electronic device of claim 10, wherein the case is formed with a contact portion that is in contact with the auxiliary heat dissipation trace.

12. The electronic device of claim 11, wherein the case is made of a conductive material including a heat-dissipating plastic.
